# EUROPÄISCHE PATENTANMELDUNG

(11) **EP 1 727 408 A1**
(43) Veröffentlichungstag der Anmeldung: **29.11.2006**
(21) Anmeldenummer: 05010476.9
(22) Anmeldetag: 13.05.2005
(51) Int. Cl.: H05K 3/10

(54) **Textil mit einem Leiterbahnsystem und Verfahren zu dessen Herstellung**

(71) Anmelder: Eidgenössische Technische Hochschule Zürich, 8092 Zürich (CH)
(72) Erfinder: Locher, Ivo, c/o Electronics Laboratory, CH-8092 Zurich (CH); Troester, Gerhard, c/o Electronics Laboratory, CH-8092 Zürich (CH)
(74) Vertreter: Wunderlich, Rainer

(57) **Zusammenfassung**

Die Erfindung betrifft ein Textil mit einem Leiterbahnsystem sowie ein Verfahren zu dessen Herstellung. Das Leiterbahnsystem weist eine Anordnung einer Vielzahl elektrischer Leiterbahnen auf. An bestimmten elektrischen Leiterbahnen wird mindestens eine elektrische Komponente angeschlossen. Gemäß der Erfindung ist ein Adapterelement zwischen der elektrischen Komponente und dem Leiterbahnsystem angeordnet. Das Adapterelement weist einerseits zumindest einen Anschlussbereich auf, welcher an die Anordnung der elektrischen Leiterbahnen angepasst ist. Andererseits weist das Adapterelement zumindest einen Anschlussbereich auf, welcher an eine Anschlussanordnung der elektrischen Komponente angepasst ist.

## Beschreibung

Die Erfindung betrifft ein Textil mit einem Leiterbahnsystem, welches eine Anordnung einer Vielzahl elektrischer Leiterbahnen aufweist, und mindestens einer elektrischen Komponente, welche an bestimmten elektrischen Leiterbahnen angeschlossen ist. Weiterhin betrifft die Erfindung ein Verfahren zur Herstellung eines Textils, welches mit einem Leiterbahnsystem ausgebildet wird, welches eine Anordnung einer Vielzahl elektrischer Leiterbahnen aufweist, und mindestens eine elektrische Komponente an bestimmten elektrischen Leiterbahnen angeschlossen wird.

Derartige Textilien werden in immer stärkerem Maße nachgefragt. Heutzutage führen weite Teile der Bevölkerung elektronische Geräte dauerhaft mit sich, etwa Mobiltelefone, PDA's, MP3-Player etc. Es wird daher verstärkt versucht, derartige elektrische Geräte in Textilien zu integrieren oder Textilien mit elektrischen und elektronischen Funktionen zu versehen.

Aus der DE-A-103 07 507 und der US-A-2004/0259391 sind beispielsweise Textilien bekannt, in welchen einzelne elektrische Leiterbahnen angeordnet sind. Diese elektrischen Leiterbahnen werden mit bestimmten elektrischen Komponenten verbunden, welche auf dem Textil befestigt werden.

Zu diesem Zweck weisen die elektrischen Komponenten eine Anschlussanordnung auf, welche an die Leiterbahnanordnung in dem Textil angepasst ist. Allerdings ist das Verbinden der elektrischen Komponenten nicht unproblematisch, insbesondere wenn ein Anschluss an ein Leiterbahnnetz mit geringem Netzabstand und elektrische Komponenten mit einer Vielzahl von verschiedenen Anschlüssen angebracht werden müssen. Neben dem elektrischen Verbinden muss zudem die elektrische Komponente zuverlässig mechanisch auf dem Textil befestigt werden. Hierbei können immer wieder Mängel bei der elektrischen und/oder mechanischen Verbindung der elektrischen Komponente mit dem Textil auftreten.

Der Erfindung liegt die **Aufgabe** zugrunde, ein Textil und ein Verfahren zu dessen Herstellung anzugeben, mit welchen elektrische Komponenten einfach und zugleich zuverlässig mit dem Textil verbindbar sind.

Die Aufgabe wird nach der Erfindung zum einen durch ein Textil mit den Merkmalen des Anspruchs 1 und zum anderen durch ein Verfahren mit den Merkmalen des Anspruchs 9 gelöst. Bevorzugte Ausführungsformen sind in den jeweils abhängigen Ansprüchen angegeben.

Das erfindungsgemäße Textil ist dadurch gekennzeichnet, dass ein Adapterelement zwischen der elektrischen Komponente und dem Leiterbahnsystem angeordnet ist, dass das Adapterelement einerseits zumindest einem Anschlussbereich aufweist, welcher an die Anordnung der elektrischen Leiterbahnen angepasst ist, und dass das Adapterelement andererseits zumindest einen Anschlussbereich aufweist, welcher an eine Anschlussanordnung der elektrischen Komponente angepasst ist.

Ein Grundgedanke der Erfindung kann darin gesehen werden, die elektrische Komponente nicht mehr unmittelbar auf dem Textil anzubringen. Zur Verbindung wird ein zwischengelagertes Adapterelement eingesetzt, welches einerseits speziell auf die Struktur des Leiterbahnsystems des Textils und andererseits speziell auf die Anschlussanordnung der elektrischen Komponente angepasst ist. Hierdurch ist es nicht mehr erforderlich, dass entweder die Leiterbahnstruktur des Textils an die anzubringende elektrische Komponente oder die Anschlussanordnung der elektrischen Komponente an das Leiterbahnsystem speziell angepasst werden muss. Dies ermöglicht einen erhöhten Freiheitsgrad bei der Wahl und Ausbildung des Leiterbahnsystems im Textil und der Auswahl der elektrischen Komponenten. Gemäß der Erfindung ist es nunmehr auch ohne weiteres möglich, verschiedenste elektrische Komponenten, wie elektronische Bausteine, Sensoren, Aktoren, Energiequellen, Schaltern etc. mit den unterschiedlichsten Anschlussanordnungen auf einem Textil mit einheitlicher Leiterbahnstruktur anzubringen.

Ein weiterer Vorteil der Erfindung liegt darin, dass das Adapterelement mit hoher Festigkeit sowohl mit dem Textil als auch mit der elektrischen Komponente verbunden werden kann. Es wird so eine sichere und zugleich zuverlässige elektrische und mechanische Verbindung zwischen dem Textil und der elektrischen Komponente erreicht.

Grundsätzlich kann das Adapterelement mit einer beliebigen Dicke und starr ausgebildet werden.

Eine bevorzugte Ausführungsform der Erfindung besteht darin, dass das Adapterelement als eine dünne, insbesondere flexible Platte, ausgebildet ist. Die Platte weist dabei eine Dicke von vorzugsweise zwischen 0,1 mm bis 3 mm auf, wobei die Anschlussbereiche auf den beiden Seiten der Platte miteinander elektrisch verbunden sind.

Nach der Erfindung ist es besonders vorteilhaft, dass das Adapterelement eine Flexibilität und/oder Elastizität aufweist, welche kleiner als die des Textils, jedoch größer als die der elektrischen Komponente ist. Das Adapterelement dient dabei also auch zur Anpassung der stark unterschiedlichen mechanischen Eigenschaften des sehr flexiblen Textils mit der üblicherweise starren elektrischen Komponente. Auf diese Weise wird bei der Nutzung des Textils einem unerwünschten Lösen der starren elektrischen Komponente von dem weichen, verformbaren Textil vorgebeugt. Das Adapterelement ist vorzugsweise als eine Schicht oder eine Folie aus einem geeigneten Kunststoff, etwa PE, PA, PU, PVC, FR-3, FR-4 etc. ausgebildet.

Für eine besonders gute Verbindung ist es erfindungsgemäß, dass das Adapterelement flächenmäßig größer ist als eine Grundfläche der elektrischen Komponente. Dies erlaubt eine mechanisch besonders gute Befestigung des Adapterelementes auf dem Textil. Zudem kann auch bei einem sehr engen Leiterbahnnetz von unter 1 mm Leiterbahnabstand eine zuverlässige elektrische Verbindung durch weit auseinander liegende Anschlussbereiche erstellt werden. Die Gefahr eines unbeabsichtigten elektrischen Kurzschlusses wird praktisch vermieden.

Zudem kann das Adapterelement dafür genutzt werden, mehrere elektrische Komponenten aufzunehmen.

Grundsätzlich kann das elektrische Leiterbahnsystem auf unterschiedlichste Weise auf oder in dem Textil angeordnet werden. So kann das Leiterbahnsystem aufgedruckt oder durch eine elektrochemische Behandlung des Textils erzeugt werden. Das Leiterbahnsystem kann dabei eine beliebige Anordnung, beispielsweise nur parallele Leiterbahnen, aufweisen. Nach der Erfindung ist es jedoch besonders bevorzugt, dass das Leiterbahnsystem eine gitterförmige oder netzförmige Anordnung der Leiterbahnen aufweist, welche in das Textil eingewebt sind. Eine derartige Anordnung stört den normalen Gebrauch des Textils, beispielsweise als Kleidung, am wenigsten. Zudem können durch elektrisches Verbinden einzelner sich kreuzender Leiterbahnen bzw. durch entsprechendes Durchtrennen einzelner Bahnen hochkomplexe Leiterbahnstrukturen relativ einfach in dem Textil ausgebildet werden. Der Gitter- oder Netzabstand der sich im Wesentlichen rechtwinklig kreuzenden Leiterbahnen beträgt vorzugsweise zwischen 0,2 mm und 20 mm.

Insbesondere bei sehr engmaschigen Leiterbahnanordnungen ist es erfindungsgemäß, dass der Anschlussbereich des Adapterelementes auf der zum Leiterbahnsystem gerichteten Seite für eine schräg zu den Leiterbahnen verlaufenden Anordnung ausgebildet ist. So kann etwa bei einem quadratischen Gitterraster mit einem Gitterabstand D bei einer um 45° zu den Leiterbahnen geschwenkten Anordnung des Adapterelementes mit linienförmig angeordneten Anschlussbereichen ein um den Faktor etwa 1,4 höherer Abstand zwischen den einzelnen Verbindungspunkten erreicht werden. Dies ist gerade bei sehr kleinen elektronischen Komponenten und einem sehr feinen Gitterraster ein großer Vorteil für eine zuverlässige, kurzschlussfreie elektrische Verbindung. Zudem können durch eine solche Anordnung Schnitte in das Textil zur Leitungsunterbrechung vermieden werden. Dies erhöht Festigkeit und Stabilität des Textils.

Eine Fertigungsvereinfachung ergibt sich erfindungsgemäß dadurch, dass das Adapterelement auf zumindest einer Seite mit einem Haftmittel versehen ist. Das Haftmittel kann dabei ein Kleber oder eine Kunststoffschicht sein, welches unter entsprechender thermischer, chemischer oder mechanischer Behandlung mit dem Grundgewebe des Textils bzw. der elektrischen Komponente eine feste, stabile Verbindung eingeht. Sofern ein Haftmittel auf beiden Seiten des Adapterelementes verwendet wird, kann es sich hierbei entsprechend dem Textil bzw. der elektrischen Komponente um unterschiedliche, elektrisch isolierende Mittel handeln. Auf den Anschlussbereichen kann entsprechend ein elektrisch leitendes Haftmittel aufgebracht sein.

Gemäß der Erfindung ist weiterhin ein Adapterelement vorgesehen, welches dadurch gekennzeichnet ist, dass einerseits zumindest ein Anschlussbereich vorgesehen ist, welcher an einer Anordnung elektrischer Leiterbahnen eines Leiterbahnsystems eines Textils angepasst ist, und dass andererseits zumindest ein Anschlussbereich vorgesehen ist, welcher an einer Anschlussanordnung einer elektrischen Komponente angepasst ist. Dieses Adapterelement kann als eine einfach herzustellende, dünne Schicht oder Folie in einer großen Variantenvielfalt kostengünstig hergestellt werden. Auf diese Weise können elektrische Komponenten mit den unterschiedlichsten Anschlussanordnungen an ein Textil mit einheitlichem Leiterbahnsystem angebracht werden. Die Anpassung der ersten Anschlussbereiche erfolgt so, dass diese auf vorbereiteten Kreuzungspunkten des Leiterbahnsystems zu Liegen kommen.

Das erfindungsgemäße Verfahren zur Herstellung eines Textils ist dadurch gekennzeichnet, dass ein Adapterelement zwischen der elektrischen Komponente und dem Leiterbahnsystem vorgesehen wird, dass das Adapterelement einerseits zumindest zwei Anschlussbereiche aufweist, welche an die Anordnung der elektrischen Leiterbahnen angepasst sind und an die bestimmten elektrischen Leiterbahnen angeschlossen werden, und dass das Adapterelement andererseits zumindest einen Anschlussbereich aufweist, welcher an eine Anschlussanordnung der elektrischen Komponente angepasst ist und damit verbunden wird.

Mit diesem Verfahren lässt sich das eingangs beschriebene Textil in einfacher, zuverlässiger und zugleich besonders variabler Weise mit einer Vielzahl unterschiedlichster elektrischer Komponenten mit verschiedenen Anschlussanordnungen versehen.

Dabei ist es bevorzugt, dass die Leiterbahnen als elektrisch leitende Garne mit Außenisolierung in das Textil eingewebt werden und dass eine gewünschte Leitungsstruktur durch elektrisches Verbinden und/oder Durchtrennen bestimmter Leitergarne gebildet wird. Hierdurch kann das Leiterbahnsystem bereits zuverlässig beim Weben des Textils erzeugt werden. Das elektrische Verbinden der außenisolierten leitenden Garne erfolgt durch Entfernen der Außenisolierung, etwa mittels Laser oder durch Ätzen und anschließendes Aufbringen eines elektrischen Verbindungsmittels, etwa eines elektrisch leitenden Klebers. Das definierte Durchtrennen elektrisch leitender Garne zur Verhinderung eines unerwünschten Kurzschlusses kann ebenfalls mittels eines Lasers, durch Ätzen oder durch einen mechanischen Schneidvorgang erfolgen.

Die Erfindung wird nachfolgend anhand von Ausführungsformen weiter erläutert, welche schematisch in den Zeichnungen dargestellt sind. In den Zeichnungen zeigen:
- Fig. 1: das Anbringen einer elektrischen Komponente auf einem Textil;
- Fig. 2: eine Verbindungsanordnung zweier elektrischer Komponenten auf einem Leiterbahnsystem;
- Fig. 3: verschiedene Anschlussanordnungen auf einem Leiterbahnsystem zur Verdeutlichung von Anschlussproblemen;
- Fig. 4: das Aufbringen einer elektrischen Komponente nach der Erfindung;
- Fig. 5: eine schematische Anschlussanordnung eines erfindungsgemäßen Adapterelementes auf einem Textil;
- Fig. 6: ein erfindungsgemäßes Textil mit zwei angebrachten elektrischen Komponenten;
- Fig. 7: eine schräge Anschlussanordnung gemäß der Erfindung;
- Fig. 8: zwei Beispiele der Anschlussanordnungen an einem erfindungsgemäßen Adapterelement.

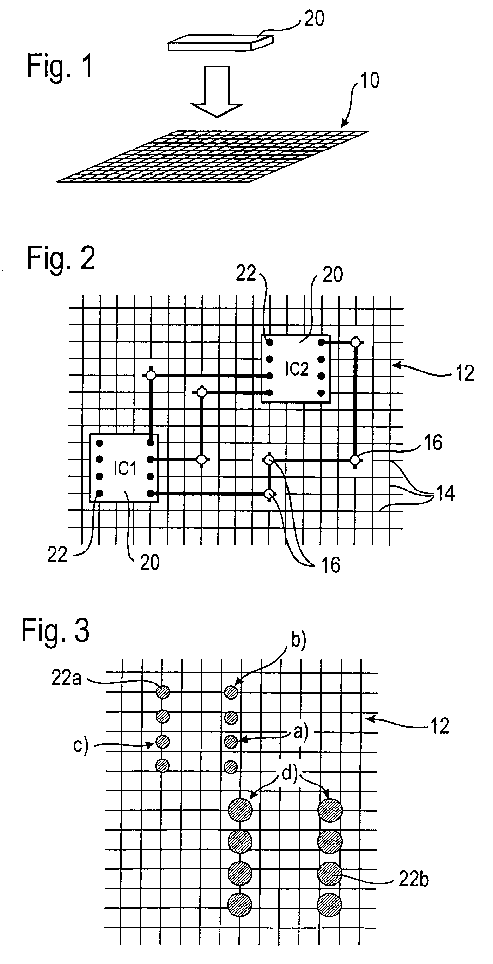

In Fig. 1 ist stark schematisiert ein erfindungsgemäßes Textil 10 gezeigt, auf welches eine elektrische Komponente 20 aufgebracht wird. Das Textil 10 besteht aus einem Grundtextil aus nicht leitenden Fadenmaterialien, insbesondere einem nicht leitenden Grundgewebe mit monofilen und/oder multifilen Garnen. Mit diesem Grundgewebe ist ein aus elektrisch leitenden Garnen bestehendes Leiterbahnsystem verwebt. Die elektrische Komponente kann ein elektronisches Bauteil, ein Sensor, ein elektrischer Aktor, aber beispielsweise auch ein mechanisches Schaltelement, beispielsweise Schalter oder Taster, sein.

In Fig. 2 ist die grundsätzliche Anordnung von zwei elektrischen Komponenten 20 auf einem Leiterbahnsystem 12 dargestellt, welches gitter- oder netzförmig in dem Textil 10 vorgesehen ist. Das Leiterbahnsystem 12 besteht aus einer Vielzahl regelmäßig angeordneter, sich kreuzender elektrischer Leiterbahnen 14. Dies sind leitende Metall-, insbesondere Kupfer- und/oder Silberdrähte, oder Garne aus elektrisch leitendem Kunststoff mit einer Außenisolierung. Zur Erzeugung einer gewünschten Leiterbahn wird an definierten Verbindungspunkten 16 in einem eng begrenzten Bereich die Außenisolierung sich kreuzender Leiterbahnen 14 entfernt und mittels eines elektrischen Verbindungsmittels eine elektrisch leitende Verbindung hergestellt.

Die einzelnen elektrischen Komponenten 20 weisen eine Anschlussanordnung 22 mit mehreren Kontaktpunkten auf, welche mit definierten Leiterbahnen 14 elektrisch verbunden werden müssen. Hierzu wird, wie vorbeschrieben, die Außenisolierung der bestimmten elektrischen Leiterbahnen 14 punktuell, vorzugsweise an Kreuzungspunkten entfernt. Diese Kontaktstellen werden mittels eines elektrisch leitenden Kunststoffs oder eines Lotes mit den Anschlusspunkten der Anschlussanordnung 22 elektrisch leitend verbunden.

Bei dem Verbinden der elektrischen Komponente 20 mit dem Leiterbahnsystem 12 können verschiedenste Probleme auftreten, welche im Zusammenhang mit Fig. 3 erläutert werden. Sofern die Anschlussanordnung 22 nicht exakt auf die Anordnung des Leiterbahnsystems 12 abgestimmt ist, oder die elektrische Komponente 20 nicht exakt justiert wird, kann es zu einer Fehlkontaktierung kommen, wie bei a) dargestellt ist. Hierbei wurde eine elektrisch leitende Verbindung zu einer gewünschten Leiterbahn 14 verfehlt. Weiterhin kann die Anschlussanordnung 22a so verschoben auf das Textil 10 aufgebracht werden, dass diese nicht exakt auf einem gewünschten Kreuzungspunkt sondern lediglich auf einer Schuss-Leiterbahn, wie bei b), oder nur auf einer Kett-Leiterbahn, wie bei c), zu liegen kommt. Auch dies kann zu Fehlkontaktierungen führen.

Sind die einzelnen Kontaktpunkte größer als ein Rasterabstand eines gitterförmigen Leiterbahnsystems 12, können, wie bei d) dargestellt, in unerwünschter Weise mehrere Leiterbahnen angeschlossen sein. Auch dies kann zu Fehlkontaktierungen und damit Fehlfunktionen der elektrischen Komponente 20 führen.

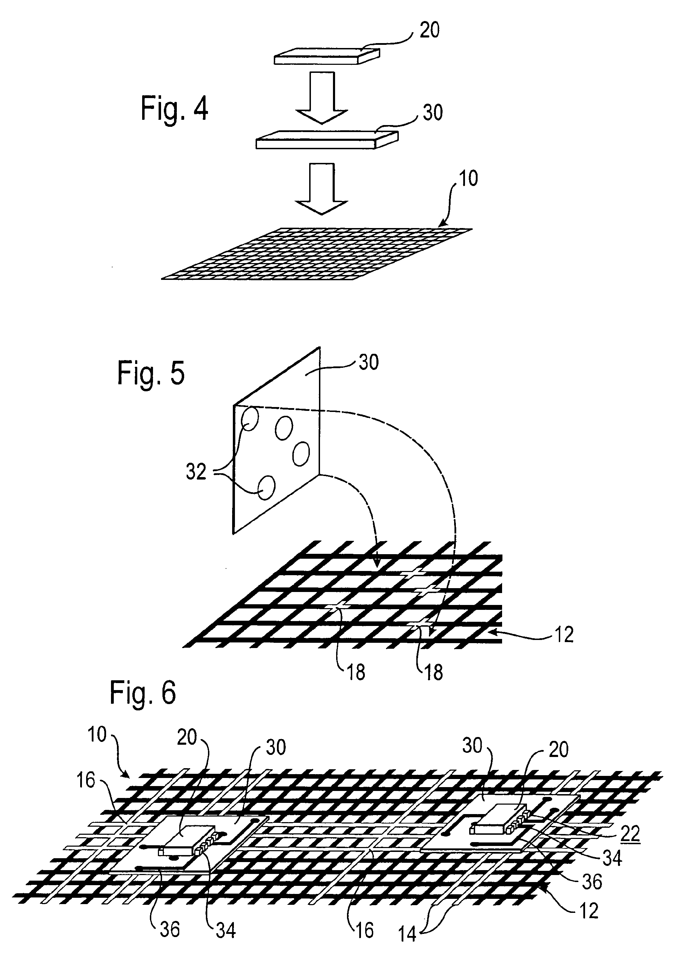

Zur Vermeidung dieser Probleme wird gemäß der Erfindung ein Adapterelement 30 zwischen dem Textil 10 mit dem Leiterbahnsystem 12 sowie der elektrischen Komponente 20 angeordnet, wie dies in Fig. 4 schematisch dargestellt ist.

Zu diesem Zweck weist das erfindungsgemäße Adapterelement 30 auf der zum Textil 10 weisenden Seite erste Anschlussbereiche 32 auf, welche entsprechend dem Raster des gitterförmigen Leiterbahnsystems 12 angeordnet sind. Korrespondierend zu den ersten Anschlussbereichen 32 auf der einen Seite des Adapterelementes 30 sind im Leiterbahnsystem 12 Anschlusspunkte 18 vorbereitet, welche in der zuvor beschriebenen Weise durch Entfernen der Außenisolierung der elektrischen Leiterbahnen 14 erzeugt worden sind. Das Befestigen des plattenförmigen oder folienartigen Adapterelementes 30 erfolgt mittels eines Haftmittels, welches mit dem Grundgewebe des Textils eine feste mechanische Verbindung eingeht. In den Bereichen der Anschlusspunkte 18 ist ein elektrisch leitender Kleber vorgesehen, welcher für eine gezielte elektrische Verbindung zwischen den Anschlusspunkten 18 des Leiterbahnsystems 12 mit den ersten Anschlussbereichen 32 des Adapterelementes 30 sorgt.

Auf diese Weise können elektrische Komponenten 20 mit den unterschiedlichsten Anschlussanordnungen 22 zuverlässig auf Textilien mit einem beliebigen Leiterbahnsystem 12 aufgebracht werden, wie dies etwa in Fig. 6 gezeigt ist. Die hier gezeigten elektrischen Komponenten 20 weisen eine Anschlussanordnung 22 mit vier eng aneinander liegenden Anschlüssen an je einer Längsseite auf. Diese Anschlüsse der Anschlussanordnung 22 der elektrischen Komponente 20 korrespondieren zu zweiten Anschlussbereichen 34, welche auf der vom Textil 10 abgewandten Seite des Adapterelementes 30 angeordnet sind. Von diesen einzelnen zweiten Anschlussbereichen 34 führen auf der Oberseite liegende Leitungen 36 zu den gewünschten Endpunkten auf dem Adapterelement 30. Die Endpunkte der Leitungen 36 liegen korrespondierend zu den ersten Anschlussbereichen 32 auf der Unterseite des Adapterelementes 30. Eine elektrische Verbindung wird durch einen Leiter erreicht, welcher von der Oberseite durch die dünne Wandstärke des Adapterelementes 30 hindurch bis zum jeweiligen Anschlussbereich 32 auf der Unterseite des Adapterelementes 30 reicht. Alternativ können die Verteilleitungen auch an der Unterseite des Adapterelementes 30 geführt sein.

Wie in Fig. 6 gut ersichtlich ist, kann so eine sehr eng anliegende Anschlussanordnung 22 der elektrischen Komponente 20 räumlich entzerrt und an ein gegebenes Leiterbahnsystem 12 angepasst werden. Das Adapterelement 30 kann in seinen Flächenausdehnungen ein Mehrfaches der Grundfläche der elektrischen Komponente 20 aufweisen, wodurch auch eine gute mechanische Befestigung der elektrischen Komponente auf dem Textil 10 erreicht wird. Zudem schützt und isoliert ein umschließender Randbereich des Adapterelementes 30 die innen liegenden elektrischen Verbindungspunkte.

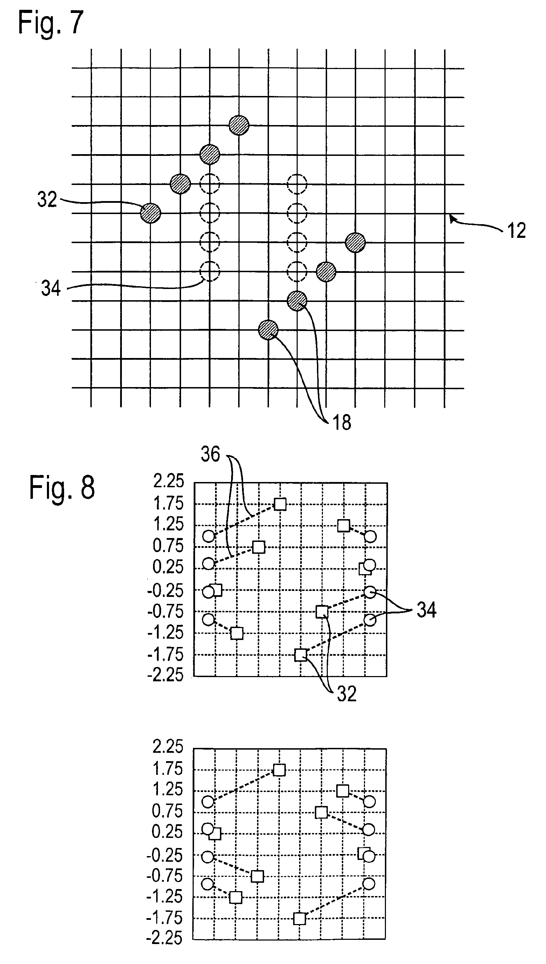

Gemäß der bevorzugten Ausführungsform nach Fig. 7 können die ersten Anschlussbereiche 32 des Adapterelementes 30 versetzt zu einem rechtwinkligen gitterförmigen Leiterbahnsystem 12 angeordnet werden. Durch diese versetzte Anordnung wird erreicht, dass Anschlusspunkte 18 nicht auf denselben Leiterbahnen 14 zu Liegen kommen. Hierdurch wird ein ansonsten notwendiges Durchtrennen der Leiterbahnen vermieden, was die Gefahr einer Fehlkontaktierung und eines Kurzschlusses weiter verringert sowie die Stabilität verbessert. Die zweiten Anschlussbereiche 34 auf der Oberseite des Adapterelementes 30 sind schematisch durch eine gestrichelte Linie dargestellt.

Die durch die Erfindung erreichte räumliche Entzerrung zwischen den ersten Anschlussbereichen 32, welche zur Verbindung mit dem Leiterbahnsystem 12 dienen, und den auf der Oberseite des Adapterelementes 30 angeordneten zweiten Anschlussbereichen 34, welche zur elektrischen Verbindung mit einer Anschlussanordnung 22 einer elektrischen Komponente 20 dienen. Zwischen den einzelnen quadratischen Kontaktpunkten der ersten Anschlussbereiche 32 auf der Unterseite des Adapterelementes 30 und den zweiten kreisförmigen Anschlussbereichen 34 auf der Oberseite des Adapterelementes 30 sind Verbindungsleitungen 36 vorgesehen, welche durch gestrichelte Linien 36 dargestellt sind.

## Patentansprüche

1. Textil mit einem Leiterbahnsystem (12), welches eine Anordnung einer Vielzahl elektrischer Leiterbahnen (14) aufweist, und mindestens einer elektrischen Komponente (20), welche an bestimmten elektrischen Leiterbahnen (14) angeschlossen ist,
**dadurch gekennzeichnet,**
**dass** ein Adapterelement (30) zwischen der elektrischen Komponente (20) und dem Leiterbahnsystem (12) angeordnet ist,
**dass** das Adapterelement (30) einerseits zumindest einen Anschlussbereich (32) aufweist, welcher an die Anordnung der elektrischen Leiterbahnen (14) angepasst ist, und
**dass** das Adapterelement (30) andererseits zumindest einen Anschlussbereich (34) aufweist, welcher an eine Anschlussanordnung (22) der elektrischen Komponente (20) angepasst ist.

2. Textil nach Anspruch 1,
**dadurch gekennzeichnet,**
**dass** das Adapterelement (30) als eine dünne, insbesondere flexible Platte ausgebildet ist.

3. Textil nach Anspruch 1 oder 2,
**dadurch gekennzeichnet,**
**dass** das Adapterelement (30) eine Flexibilität und/oder Elastizität aufweist, welche kleiner als die des Textils (10), jedoch größer als die der elektrischen Komponente (20) ist.

4. Textil nach einem der Ansprüche 1 bis 3,
**dadurch gekennzeichnet,**
**dass** das Adapterelement (30) flächenmäßig größer ist als eine Grundfläche der elektrischen Komponente (20).

5. Textil nach einem der Ansprüche 1 bis 4,
**dadurch gekennzeichnet,**
**dass** das Leiterbahnsystem (12) eine gitterförmige oder netzförmige Anordnung der Leiterbahnen (14) aufweist, welche in das Textil (10) eingewebt sind.

6. Textil nach einem der Ansprüche 1 bis 5,
**dadurch gekennzeichnet,**
**dass** der Anschlussbereich (32) des Adapterelementes (30) auf der zum Leiterbahnsystem (12) gerichteten Seite für eine schräg zu den Leiterbahnen (14) verlaufende Anordnung ausgebildet ist.

7. Textil nach einem der Ansprüche 1 bis 6,
**dadurch gekennzeichnet,**
**dass** das Adapterelement (30) auf zumindest einer Seite mit einem Haftmittel versehen ist.

8. Adapterelement für ein Textil (10) nach einem der Ansprüche 1 bis 7,
**dadurch gekennzeichnet,**
**dass** einerseits zumindest ein Anschlussbereich (32) vorgesehen ist, welcher an eine Anordnung elektrischer Leiterbahnen (14) eines Leiterbahnsystems (12) des Textils (10) angepasst ist, und
**dass** andererseits zumindest ein Anschlussbereich (34) vorgesehen ist, welcher an eine Anschlussanordnung (22) einer anzubringenden elektrischen Komponente (20) angepasst ist.

9. Verfahren zur Herstellung eines Textils (10), welches mit einem Leiterbahnsystem (12) ausgebildet wird, welches eine Anordnung einer Vielzahl elektrischer Leiterbahnen (14) aufweist, und mindestens eine elektrische Komponente (20) an bestimmten elektrischen Leiterbahnen (14) angeschlossen wird,
**dadurch gekennzeichnet,**
**dass** ein Adapterelement (30) zwischen der elektrischen Komponente (20) und dem Leiterbahnsystem (12) vorgesehen wird,
**dass** das Adapterelement (30) einerseits zumindest einen Anschlussbereich (32) aufweist, welcher an die Anordnung der elektrischen Leiterbahnen (14) angepasst ist und an die bestimmten elektrischen Leiterbahnen (14) angeschlossen wird, und
**dass** das Adapterelement (30) andererseits zumindest einen Anschlussbereich (34) aufweist, welcher an eine Anschlussanordnung (22) der elektrischen Komponente (20) angepasst ist und damit verbunden wird.

10. Verfahren nach Anspruch 9,
**dadurch gekennzeichnet,**
**dass** die Leiterbahnen (14) als elektrisch leitende Garne mit einer Außenisolierung in das Textil (10) eingewebt werden und
**dass** eine gewünschte Leitungsstruktur durch elektrisches Verbinden und/oder Durchtrennen bestimmter leitender Garne gebildet wird.

## Geänderte Patentansprüche

### Geänderte Patentansprüche gemäss Regel 86(2) EPÜ.

**1.** Textil mit
- einem Leiterbahnsystem (12), welches eine gitterförmige Anordnung einer Vielzahl elektrischer Leiterbahnen (14) aufweist,
- mindestens einer elektrischen Komponente (20), welche an bestimmten elektrischen Leiterbahnen (14) angeschlossen ist, und
- einem Adapterelement (30), welches zwischen der elektrischen Komponente (20) und dem Leiterbahnsystem (12) angeordnet ist,
**dadurch gekennzeichnet,**
**dass** das Adapterelement (30) einerseits zumindest einen Anschlussbereich (32) mit mindestens zwei Anschlusspunkten (18) aufweist, welcher an die Anordnung der elektrischen Leiterbahnen (14) angepasst ist,
**dass** das Adapterelement (30) andererseits zumindest einen Anschlussbereich (34) aufweist, welcher an eine Anschlussanordnung (22) der elektrischen Komponente (20) angepasst ist, und
**dass** die Anschlusspunkte (18) derart versetzt in Bezug auf die gitterförmige Anordnung des Leiterbahnsystems (12) angeordnet sind, dass die Anschlusspunkte (18) nicht auf denselben Leiterbahnen (14) liegen.

**2.** Textil nach Anspruch 1,
**dadurch gekennzeichnet,**
**dass** das Adapterelement (30) als eine dünne, insbesondere flexible Platte ausgebildet ist.

**3.** Textil nach Anspruch 1 oder 2,
**dadurch gekennzeichnet,**
**dass** das Adapterelement (30) eine Flexibilität und/oder Elastizität aufweist, welche kleiner als die des Textils (10), jedoch größer als die der elektrischen Komponente (20) ist.

**4.** Textil nach einem der Ansprüche 1 bis 3,
**dadurch gekennzeichnet,**
**dass** das Adapterelement (30) flächenmäßig größer ist als eine Grundfläche der elektrischen Komponente (20).

**5.** Textil nach einem der Ansprüche 1 bis 4,
**dadurch gekennzeichnet,**
**dass** das Leiterbahnsystem (12) in das Textil (10) eingewebt ist.

**6.** Textil nach einem der Ansprüche 1 bis 5,
**dadurch gekennzeichnet,**
**dass** das Adapterelement (30) auf zumindest einer Seite mit einem Haftmittel versehen ist.

**7.** Adapterelement für ein Textil (10) nach einem der Ansprüche 1 bis 6,
**dadurch gekennzeichnet,**
**dass** einerseits zumindest ein Anschlussbereich (32) mit mindestens zwei Anschlusspunkten (18) vorgesehen ist, welcher an eine gitterförmige Anordnung elektrischer Leiterbahnen (14) eines Leiterbahnsystems (12) des Textils (10) angepasst ist,
**dass** andererseits zumindest ein Anschlussbereich (34) vorgesehen ist, welcher an eine Anschlussanordnung (22) einer anzubringenden elektrischen Komponente (20) angepasst ist, und
**dass** die Anschlusspunkte (18) derart versetzt in Bezug auf die gitterförmige Anordnung elektrischer Leiterbahnen (14) angeordnet sind, dass die Anschlusspunkte (18) nicht auf denselben Leiterbahnen (14) zu liegen kommen.

**8.** Verfahren zur Herstellung eines Textils (10), welches mit einem Leiterbahnsystem (12) ausgebildet wird, welches eine gitterförmige Anordnung einer Vielzahl elektrischer Leiterbahnen (14) aufweist, und mindestens eine elektrische Komponente (20) an bestimmten elektrischen Leiterbahnen (14) angeschlossen wird, wobei
ein Adapterelement (30) zwischen der elektrischen Komponente (20) und dem Leiterbahnsystem (12) vorgesehen wird,
**dadurch gekennzeichnet,**
**dass** das Adapterelement (30) einerseits zumindest einen Anschlussbereich (32) mit mindestens zwei Anschlusspunkten (18) aufweist, welcher an die gitterförmige Anordnung der elektrischen Leiterbahnen (14) angepasst ist und an die bestimmten elektrischen Leiterbahnen (14) angeschlossen wird,
**dass** das Adapterelement (30) andererseits zumindest einen Anschlussbereich (34) aufweist, welcher an eine Anschlussanordnung (22) der elektrischen Komponente (20) angepasst ist und damit verbunden wird, und
**dass** die Anschlusspunkte (18) derart versetzt in Bezug auf die gitterförmige Anordnung des Leiterbahnsystems (12) angeordnet werden, dass die Anschlusspunkte (18) nicht auf denselben Leiterbahnen (14) liegen.

**9.** Verfahren nach Anspruch 8,
**dadurch gekennzeichnet,**
**dass** die Leiterbahnen (14) als elektrisch leitende Garne mit einer Außenisolierung in das Textil (10) eingewebt werden und
**dass** eine gewünschte Leitungsstruktur durch elektrisches Verbinden und/oder Durchtrennen bestimmter leitender Garne gebildet wird.
